# EUROPEAN PATENT APPLICATION

(11) **EP 4 443 236 A1**
(43) Date of publication of application: **09.10.2024**
(21) Application number: 23166880.7
(22) Date of filing: 05.04.2023
(51) Int. Cl.: G03F 1/66, G03F 7/00, H01L 21/673, H01L 21/677

(54) **STOCKER COMPARTMENT**

(71) Applicant: Brooks Automation (Germany) GmbH, 78256 Steißlingen (DE)
(72) Inventor: GUGEL, Jörg, 8280 Kreuzlingen (CH)
(74) Representative: Dehns Germany Partnerschaft mbB

(57) **Abstract**

Stocker compartment for storage of EUV pod components, comprising a plurality of sub-compartments (120a to 120e), each of which sub-compartments being adapted to store one EUV pod component, the sub-compartments being arranged in a vertically stacked order, each sub-compartment of the plurality of sub-compartments defining a vertically extending front side and a vertically expending rear side, wherein a plurality of shutters (128a to 128e) is provided such that the front side of each of the plurality of sub-compartments (120a to 120e) is provided with an associated shutter out of the plurality of shutters (128a to 128e), each associated shutter being movable in a vertical direction in order to provide an open and a closed state of the sub-compartment (120a to 120e) to which it is associated, wherein each shutter of the plurality of shutters (128a to 128e) is movable independently of any other of the plurality of shutters.

## Description

The present invention relates to a stocker compartment for storage of EUV pod components according to the preamble of claim 1. The invention further relates to a stocker comprising a plurality of such stocker compartments.

### Background

Photolithography processes are widely used as one of the key steps in the manufacture of integrated circuits (ICs) and other semiconductor-related devices and/or structures. However, as the dimensions of features produced by such processes decrease, the importance of photolithography for the production of miniature ICs or other devices and/or structures rises.

In photolithography, a geometric pattern is transferred from a photomask (typically referred to as reticle) onto a substrate, for example a semiconductor wafer, by the use of light, a photosensitive layer and a subsequent etching step. Depending on the desired feature size on the substrate, the feature size of the reticle needs to be adapted as well as the wavelength of the light used for pattern transfer, with consideration of the Rayleigh criterion.

In order to reduce the smallest achievable feature size, it has been proposed to use extreme ultraviolet (EUV) radiation. EUV radiation is electromagnetic radiation having a wavelength within the range of 5-20 nm, for example within the range of 5-10 nm.

Any contamination of the reticle may reduce the imaging performance of the photolithographic process and may in more serious cases require the reticle to be replaced. The reticle is typically expensive and therefore any reduction in the frequency with which it must be replaced is advantageous. Furthermore, replacement of the reticle is a time consuming process, during which the photolithographic process may have to be suspended, thereby reducing its efficiency, which is undesirable.

For EUV applications, particle contamination with particle sizes of less than 10 nm as well as chemical contamination, for example by adsorption of volatile organic compounds, can be relevant.

The reticles used for such EUV applications are therefore typically stored in a storage stocker, referred to in the following simply as a stocker, and retrieved when needed in connection with the lithography exposure equipment. Usually, the reticles are contained in a double shell container (double pod) comprising a so-called EUV outer pod (EOP) and an EUV inner pod (EIP) during transportation as well as for storage within a stocker.

Such a double pod is described in further detail in US 2019/0214287 A1, for example.

Since the acceptable level of particle contamination is extremely low, friction (which leads to abrasion and thus particle generation) of the reticle against the container as well as friction of container components relative to one another need to be avoided. Therefore, typical EIPs are designed so as to accommodate one reticle in such a way that it has only very limited possibilities to move therein. They are also equipped with an additional reticle retainer configured and adapted to immobilize the reticle inside the EIP. In order to prevent contamination, the EIP is designed to enable a protective gas or vacuum to be applied to the reticle. To that end, typically orifices equipped with filter material are provided for the protective gas to enter from the EOP into the surroundings of the reticle contained in the respective EIP.

The EOP is equipped with an actuator adapted to bias the reticle immobilization means of the EIP into a retaining position, thereby immobilizing the reticle inside the EIP when the EOP is attached to the EIP. The EOP also functions to immobilize the typically two pieces of the EIP against one another to prevent friction induced abrasion.

It is to be understood that the EIP components are moveable against one another as long as they are not immobilized from outside. In order to avoid friction induced abrasion caused by such movement, the EOP conventionally provides such immobilization functionality for the EIP while also providing protection against the surrounding atmosphere, which is necessary e.g. during transport between a storing position and process tools requiring reticles for operation.

EOPs are rather bulky, leading to high space requirements or "footprint" for stockers storing EUV reticles. Furthermore, they are made of polymeric material, which is also prone to abrasion and outgassing of volatile organic compounds.

### Summary

The present invention addresses these problems by providing a stocker compartment and a stocker with features according to the respective independent claims. Advantageous embodiments and additional features are provided in the dependent claims and further discussed in the following description.

A stocker compartment for storage of EUV pod components, especially an EIP containing or at least configured and adapted to contain a reticle, according to the present invention, comprises a plurality of sub-compartments, each of which sub-compartments being adapted to store one EUV pod component, the sub-compartments being arranged in a vertically stacked order, each sub-compartment of the plurality of sub-compartments defining a vertically extending front side and a vertically expending rear side, wherein a plurality of shutters is provided such that the front side of each of the plurality of sub-compartments is provided with an associated shutter out of the plurality of shutters, each associated shutter being movable in a vertical direction in order to provide an open and a closed state of the sub-compartment to which it is associated, wherein each shutter of the plurality of shutters is movable independently of any other of the plurality of shutters. A shutter being independently movable from any other of the plurality of shutters especially means that in case one shutter is displaced in a vertical direction from a closed into an open position, such that its associated sub-compartment changes its state from closed to open, all other shutters of the compartment remain in their respective closed positions (i.e. providing closed states of their associated sub-compartments). Hereby, it is no longer necessary, as in prior art solutions, to move a number of shutters simultaneously in order to open only a single sub-compartment. This minimises mechanical movement within the stocker compartment, thus leading to less particle generation due to abrasion effects. Hereby, the vertical space required to operate a stocker compartment is also minimised.

Storing EIPs in stocker sub-compartments as described above provides an additional measure of safety in connection with potential earthquakes, as the EIPs containing reticles are safely stored within said sub-compartments, which are usually in their closed state by means of their respective shutters being secured in their closed positions.

Advantageously, each shutter of the plurality of shutters is movable either vertically upwards or vertically downwards such that in an open state of a sub-compartment an associated shutter is partly or fully positioned horizontally in front of or behind a shutter associated with a vertically adjacent sub-compartment. For example, by providing the uppermost shutter to be displaceable vertically downwards, and the lowermost shutter to be moveable vertically upwards, the vertical space requirement for operating a stocker compartment can be further minimised, as the uppermost shutter in both its closed and open state does not extend beyond the height or the upper edge of the stocker compartment, and analogously the lowermost shutter in its open or closed state does not extend below the lower edge of the stocker compartment.

Expediently, the rear side of each of the plurality of sub-compartments is provided with a rear wall, and each associated shutter and each rear wall of the plurality of sub-compartments is provided with a plurality of openings adapted to permit a flow of purging fluid/gas through each of the plurality of sub-compartments. Hereby, a highly effective purge gas flow through the respective sub-compartments can be provided, so that contamination by airborne particles of an EIP stored in a sub-compartment can be minimised.

Advantageously, each shutter of the plurality of shutters is provided with a plurality of openings arranged in a pattern, such that in case of an associated shutter of a compartment being vertically moved such that it is positioned horizontally in front of or behind a shutter associated with a vertically adjacent sub-compartment, the patterns of the moved shutter and the shutter of the vertically adjacent sub-compartment are aligned with respect to one another. Hereby, a laminarity of a purge gas flow through the sub-compartments can be upheld even if a sub-compartment temporarily has two shutters positioned at its front side.

According to a preferred embodiment of the invention, the shutters are secured in their positions defining closed and open states of the sub-compartments with which they are associated by means of a magnetic securing mechanism. Such a magnetic securing mechanism can be implemented in either a contacting way, in which for example magnets provided on the movable shutters contact non-movable stopper elements, or in a noncontacting way, in which for example magnets provided on the movable shutters are brought into the vicinity of such stopper elements, such that a sufficient force of attraction is generated between magnets and stopper elements to secure the shutters in this position. Hereby, abrasion effects associated with the movement of the shutters can be further minimised.

Advantageously, a guide rail mechanism for guiding the shutters between their positions defining opening and closed states of respective sub-compartments with which they are associated is provided.

According to a preferred embodiment, the magnetic securing mechanism and/or the guide rail-mechanism is provided in a shielded environment separated from each of the plurality of sub-compartments. By providing a magnetic securing mechanism and/or a guide rail mechanism within a shielded environment, i.e. an environment shielded from the sub-compartments containing the EIPs, contamination of the sub-compartments by means of abrasion effects caused by the magnetic securing mechanism or the guide rail mechanism can be avoided or at least further minimised.

Expediently, the shielded environment for the rail mechanism is provided with an exhaust mechanism for extracting particles generated during activity of the rail mechanism from the shielded.

A stocker according to the invention comprises at least one stocker compartment as discussed above and a robot mechanism adapted to move each one of the plurality of shutters to provide an open or closed state of a sub-compartment, with which a shutter moved by the robot mechanism is associated. A stocker comprising more than one compartment can be equipped with a single robot mechanism, serving all compartments, or with a plurality of robot mechanisms, for example two or three.

The present invention enables reducing the required space for storing reticles while ensuring at least the same level of contamination and damage protection provided by conventional systems. Chemical contamination during storage from outgassing EOPs is prevented and mechanical damage protection improved over storing reticles in double pods. For example, EOPs can easily be damaged during an earthquake. Storing EIPs containing reticles in sub-compartments as described above is substantially safer, even under challenging conditions as earthquakes, as will be understood from the following description.

Aspects which need to be taken into account when developing such an improved storage concept include that it is highly undesirable to change the way the reticles are provided to the photolithographic process equipment, this typically being the most complicated and costly part of a semiconductor production facility.

Therefore, since the photolithographic process equipment is typically adapted to receive double pods, means for providing a conventional double pod to the photolithographic process equipment are advantageously provided with the improved compartment or stocker.

Be it noted that all the method steps discussed herein below can advantageously be carried out in an automated manner, for example by a robotic component.

### Brief description of the drawings

Advantages and further aspects of the invention will now be discussed further with reference to the appended drawings. Herein,
Figure 1 shows a perspective view of a first preferred embodiment of a stocker according to the invention,
Figure 2 shows a partly cut away view of the stocker as shown in Figure 1,
Figure 3 shows a view corresponding to that of Figure 2, in which one sub-compartment is in an open state, and
Figs. 4a-4d show side sectional and front views of a stocker illustrating a magnetic securing mechanism for securing a shutter in its closed and open positions.

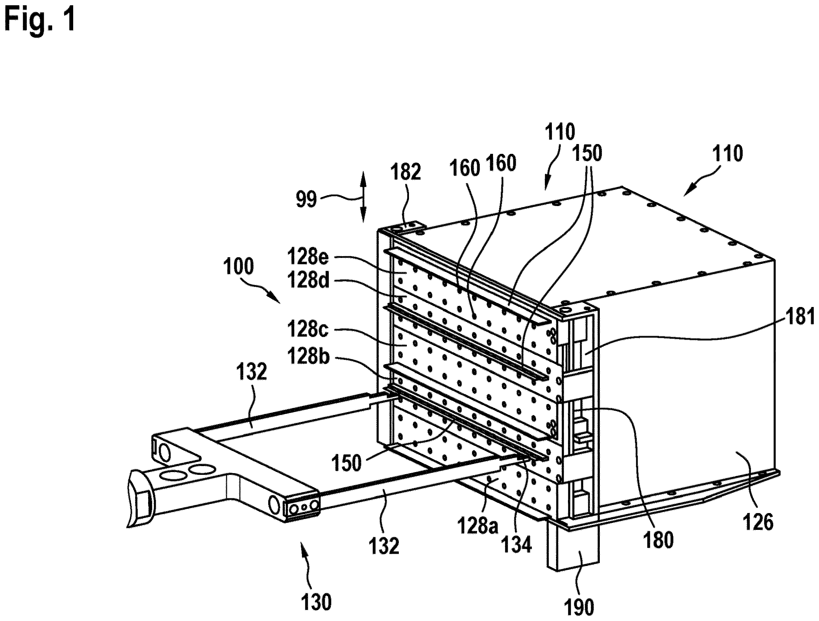

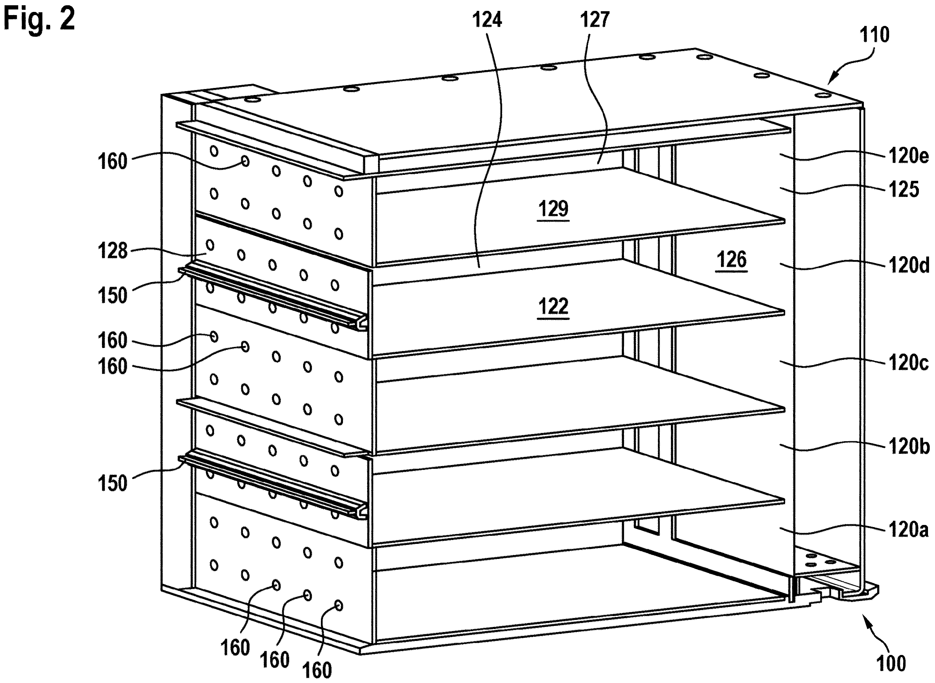

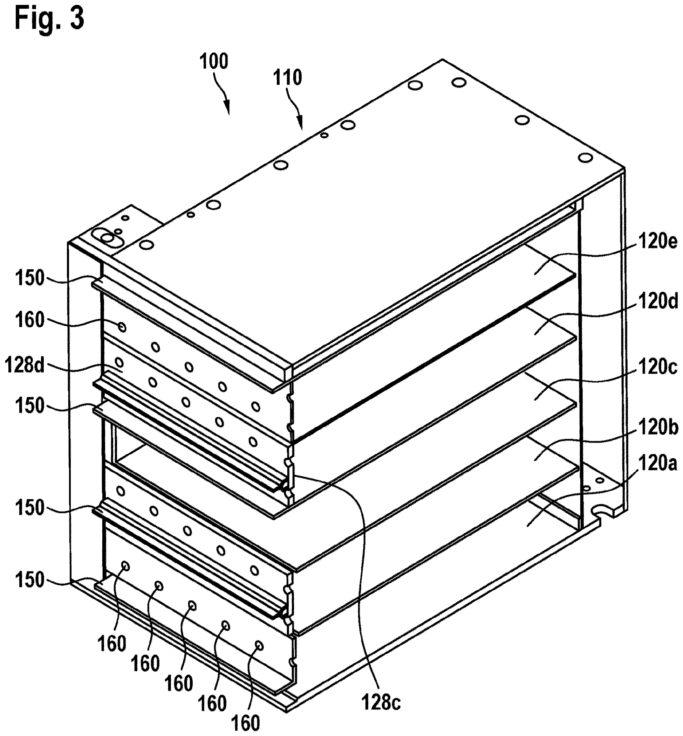

In Figures 1 to 3, a reticle stocker is generally designated 100. In the embodiment shown, it comprises one stocker compartment 110 including a plurality of five sub-compartments (for ease or reference designated 120a to 120e in the direction from lowermost to uppermost sub-compartment, as can be seen in Figures 2 and 3) arranged vertically one above the other. The stocker 100 further comprises a robot mechanism 130. Each sub-compartment 120a to 120e is adapted to house one inner pod of an EUV double pod, the so called EIP.

For many applications, a stocker will typically comprise a plurality of stocker compartments 110 vertically arranged one above the other and/or horizontally next to one another, which can advantageously be served by a single robot mechanism 130. To simplify the illustration, a stocker with only one compartment is shown in the Figures.

Each sub-compartment 120a to 120e is defined by a floor 122, a ceiling 124, a rear wall 126, a shutter 128a to 128e and side walls 125 and 127. The side walls 125, 127 as well as rear wall 126 can be provided as unitary walls extending over all sub-compartments 120a to 120e. As can be seen for example in Figure 2, a ceiling 124 of for example sub-compartment 120d corresponds to a floor 129 of an adjacent sub-compartment 120e vertically above said sub-compartment 120d.

Each sub-compartment 120a to 120e is adapted to safely house and retain one EIP containing a reticle, or at least an EIP configured and adapted to store one reticle. In order to ensure that the environment within the EIP remains free from contamination, there is provided in each sub-compartment 120 a to 120e a clamping device (not shown) configured and adapted to immobilize the components of the EIP and the reticle contained within the EIP relative to one another. Such a clamping device can either be permanently provided within each sub-compartment 120a to 120e, or be clamped around an EIP before it is introduced into a sub-compartment. In case of a clamping device permanently located within a sub-compartment, this will expediently also serve to immobilize the EIP relative to the sub-compartment. In case the clamping device is inserted into the sub-compartment together with an EIP (either containing a reticle or not), expediently there is provided a separate mechanism for immobilising the EIP within the sub-compartment.

In Figures 1 and 2, each sub-compartment 120a to 120e is shown in its closed state, i.e. the front side of each sub-compartment 120a to 120e is limited, i.e. closed by a respective shutter 128a to 128e associated therewith.

Each shutter 128a to 128e is, in an individual manner, vertically displaceable either in a vertically upward, or a vertically downward direction (illustrated by means of double headed arrow 99 in Figure 1) by means of robot mechanism 130, in order to provide an open and closed states for each respective sub-compartment.

It is now referred to Figure 3, where sub-compartment 120c is shown in its open state, by means of its shutter 128c having been displaced in a vertically upward direction, such that it is positioned horizontally behind shutter 128d of the upper adjacent sub-compartment 120d.

To achieve such a displacement, the arms 132 of robot mechanism 130 are provided with grippers 134 adapted to engage handling ridges 150 provided on each shutter 128a to 128e. A vertically upward movement of arms 132 of robot mechanism thus leads to an upward displacement of any one of the shutters 128a to 128e gripped or otherwise engaged by grippers 134.

The use of such a robot mechanism renders unnecessary the provision of complex systems including active drives and corresponding sensors for the respective shutters. The provision of a robot mechanism thus minimises abrasion effects and thus contamination in the vicinity of the stocker compartment 110. The robot mechanism is further configured and adapted to handle EUV pod components, especially EIPs stored in the sub-compartments. For example, after opening a sub-compartment by vertically displacing its shutter, it can place an EIP in the sub-compartment, or remove an EIP from the sub-compartment.

In order to minimise a height requirement of a stocker compartment, the shutter 128e of uppermost sub-compartment 120e is preferably displaceable vertically downwardly, whereas shutter 128 of the lowermost sub-compartment 120a is displaceable vertically upwardly. The shutters 128b to 128d of the intermediate three sub-compartments 120b to 120d can either be displaceable upwardly or downwardly. In the embodiment shown, the shutters 128a and 128c are displaceable upwardly, and the shutters 128b, 128d and 128e downwardly. Hereby, the height requirement during usage of the compartment 110 is no higher than the physical height of the compartment 110 itself.

In order to enable displacement of the respective shutters 128a to 128e such that they can be positioned behind one another in a horizontal direction, shutters 128b and 128d are positioned with a small horizontal offset relative to shutters 128a, 128c and 128e, as can be seen from Figures1-3. Be it noted in this connection that the position of handling ridges 150 on the respective shutters 128a to 128e depends on whether they are provided in the horizontally slightly forwardly or backwardly offset positions. For example, as can be seen in Figure 1, shutter 128d is in the horizontally slightly forwardly offset position, and its handling ridge 150 is provided in a central position relative to the vertical extension of the shutter. This handling ridge can easily be gripped and displaced by robot mechanism 130. In contrast hereto, the handling ridge for example of shutter 128e, which is in the horizontally backwardly offset position, is provided with a handling ridge 150 at or in the vicinity of its upper edge. This ensures that robot mechanism 130 can grip handling ridge 150 of shutter 128e, and displace it downwardly without coming into contact with shutter 128d positioned immediately below shutter 128e.

During displacement by means of robot mechanism 130, the shutters 128a to 128e are guided by means of a guide rail mechanism 180 provided at both lateral sides of the shutters. The guide rail mechanism is arranged within a shielded environment 181 provided by respective housings 182 on both lateral sides of the shutters 128. In order to visualise the guide rail mechanism 180, housing 182 on the lateral right side of the shutters 128 is shown with one housing wall removed in Figure 1.

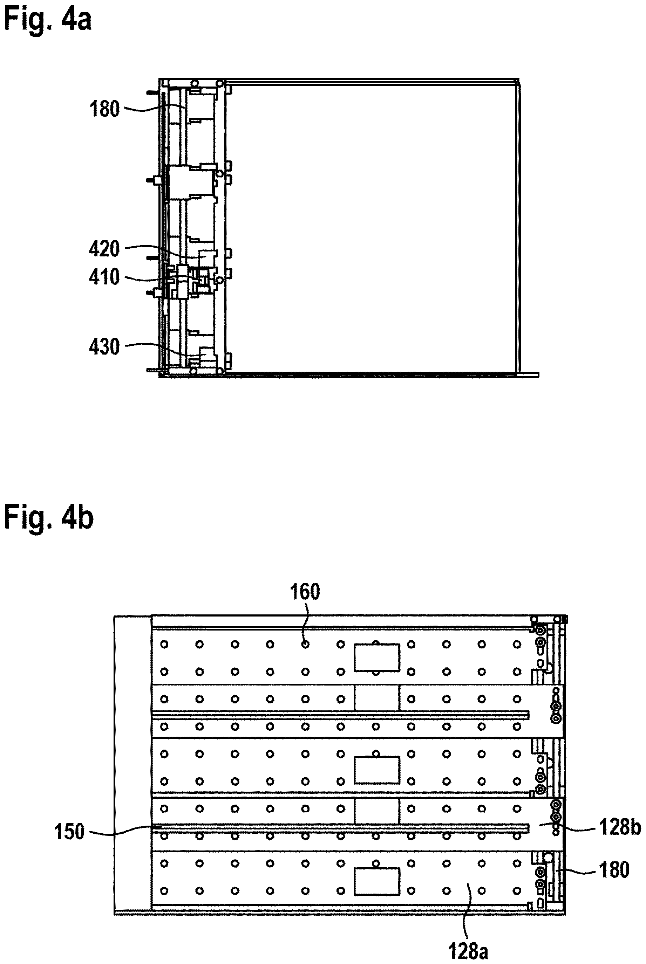

In their respective closed and open positions, the shutters 128a to 128e are held in place in a contactless way by means of a magnetic securing mechanism. This will be further explained below with reference to Figures 4a to 4d

In order to further minimise the danger of contamination caused by abrasion during displacement of the shutters along the guide rail mechanism, the housings 182 are provided with an exhaust mechanism, for example comprising suction means. Such an exhaust mechanism is schematically indicated and designated 190 in Figure 1. It can be configured to create a vacuum within shielded environments 181 by extracting any gases and particles present therein.

Each shutter 128a to 128e is provided with openings 160, through which a purge gas provided to flow through the respective sub-compartments 120a to 120e can exit. Typically, such a purge gas enters the sub-compartments 120a to 120e through (not shown) openings provided in rear wall 125, and flows around an EIP provided within the sub-compartment and towards openings 160 provided in shutters 128a to 128e in a laminar way. Such a purge gas flow requires substantially less purge gas compared to conventional solutions. In order to further minimise purge gas requirement, the openings in rear wall 125 and in the shutters 128a to 128e can be adapted to correspond to one another

For example, by providing the openings in rear wall 125 in an identical or similar pattern as in shutters 128a to 128e, laminarity of the flow can be enhanced, thereby reducing purge gas consumption.

Also, by providing the openings of the respective shutters in corresponding patterns, it can be ensured that in case of opening of a sub-compartment by displacing its associated shutter into a position in front of or behind the shutter of an adjacent sub-compartment, the respective openings of both these shutters come into alignment, thus maintaining a laminar flow while exiting a sub-compartment even if this is momentarily limited by two shutters on its front side. In order to maximise this effect, the two shutters arranged horizontally behind each other are only displaced by a minimal distance chosen to ensure that no abrasion occurs while one shutter is being moved in front of or behind the other.

Advantageously, there is provided a measurement device for measuring airborne particle concentration in the shielded environment within housings 182. For example by monitoring the concentration of particles generated during mechanical movement of guide rail mechanism 180, the wear and tear of this mechanism can be monitored, such that components can be replaced when necessary.

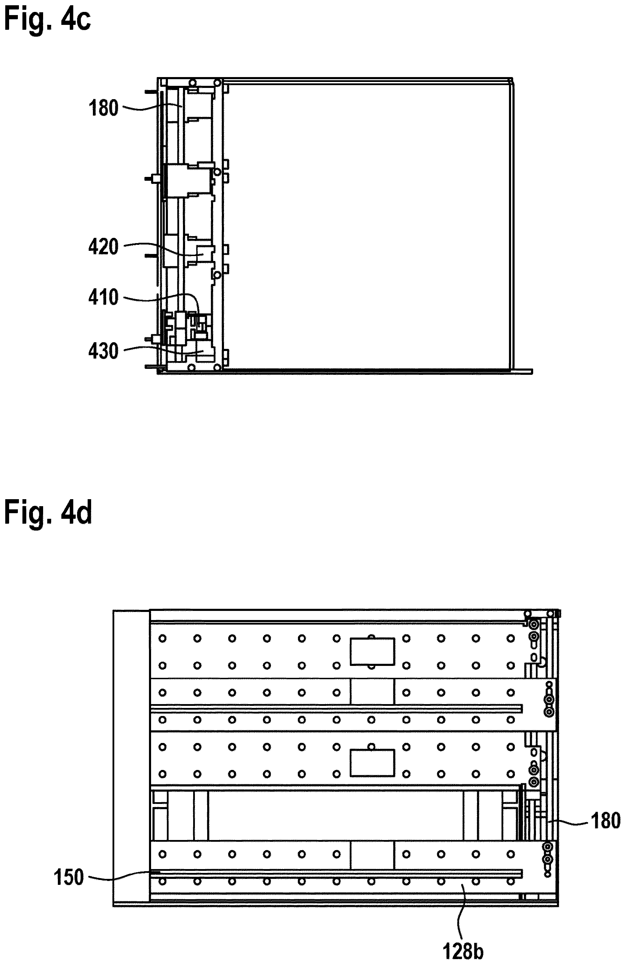

Referring to Figures 4a to 4d, a preferred embodiment of a magnetic securing mechanism for holding the shutters in their respective closed and open positions will now be described. Figures 4a and 4b are side sectional and front views respectively of reticle stocker compartment 110, wherein all shutters 128a to 128 e are in their closed position. Figures 4c and 4d are side sectional and front views respectively of reticle stocker compartment 110, wherein shutter 128b is in its open position, while all other shutters 128a and 128c to 128e remain in their closed position. In order to reach its open position, shutter 128 is moved downward (by means of robot mechanism 130, as described above), such that it is positioned in front of lowermost shutter 128a. Thus, in the perspective of Figure 4d, shutter 128b is visible, while shutter 128a is not visible, as it is positioned behind shutter 128b.

The shutters 128a to 128e are each provided with a magnet 410, which interacts with stopper elements 420, 430, which define the open and the closed position or the shutters. The stopper elements 420,430 are either also provided as magnets or made of magnetic material, such that the magnets 410 are subject to a force of attraction when they abut the stopper elements. Thus, as can be seen in Figure 4a, magnet 410 abutting stopper element 420 defines the closed position of shutter 128b as shown in Figure 4b, while magnet 410 abutting stopper element 430 defines the open position of shutter 128b, as shown in Figure 4d. In Figures 4a to 4d, only the magnet 410 of shutter 128b and the stopper elements 420,430 it interacts with are shown for reasons of simplicity of presentation.

The magnets 410 and the stopper elements 420,430 are also provided within the shielded environments 181 and in the vicinity of guide rail mechanism 180. Thus, abrasion effects within the shielded environments 181, by means of which contaminating particles could be generated, especially when a shutter reaches its open or closed position, can be avoided. The magnetic securing mechanism could also be provided in a contactless manner. For example, the magnets and stopper elements could be provided such that by bringing the (movable) magnets provided on the shutters into the vicinity of the non-movable stopper elements without contact a sufficient force of attraction was generated to secure the magnets and thus the shutters in the thus defined position, such that removal of the magnets out of this position, i.e. out of the range of magnetic interaction with the stopper elements, required an outside force, such as the force generated by the robot mechanism 130 gripping the handling ridges 150.

The magnetic securing mechanism can also be implemented as an electromagnetic system, wherein corresponding currents can be provided through coil members provided on the shutters and the guide rail mechanism. This solution also offers a reliable means for monitoring a position of any one of the shutters 128a to 128e.

Be it finally noted that providing reticle stocker compartments with sub-compartments each provided with shutters adds to earthquake security, as the shutters, in their closed state, effectively prevent EIPs with reticles contained therein from falling out of the sub-compartments, even in case a mechanism (e.g. a clamping device as mentioned above) securing the EIP within a sub-compartment should fail.

## Claims

1. Stocker compartment for storage of EUV pod components, comprising a plurality of sub-compartments (120a to 120e), each of which sub-compartments being adapted to store one EUV pod component, the sub-compartments being arranged in a vertically stacked order, each sub-compartment of the plurality of sub-compartments defining a vertically extending front side and a vertically expending rear side, wherein a plurality of shutters (128a to 128e) is provided such that the front side of each of the plurality of sub-compartments (120a to 120e) is provided with an associated shutter out of the plurality of shutters (128a to 128e), each associated shutter being movable in a vertical direction in order to provide an open and a closed state of the sub-compartment (120a to 120e) to which it is associated, **characterized in that**
each shutter of the plurality of shutters (128a to 128e) is movable independently of any other of the plurality of shutters.

2. Stocker compartment according to claim 1, wherein each shutter of the plurality of shutters (128a to 128e) is movable either vertically upwardly or vertically downwardly such that in an open state of a sub-compartment an associated shutter is partly or fully positioned horizontally in front of or behind a shutter associated with a vertically adjacent sub-compartment.

3. Stocker compartment according to any one of the preceding claims, wherein the rear side of each of the plurality of sub-compartments is provided with a rear wall, and each associated shutter (128a to 128e) and each rear wall of the plurality of sub-compartments (120a to 120e) is provided with a plurality of openings (160) adapted to permit a flow of purging fluid or gas through each of the plurality of sub-compartments.

4. Stocker compartment according to claim 3, wherein each shutter of the plurality of sub-compartments (120a to 120e) is provided with a plurality of openings (160) arranged in a pattern, such that in case of a shutter of a compartment being vertically moved such that it is positioned horizontally in front of or behind a shutter associated with a vertically adjacent sub-compartment, the patterns of the moved shutter and the shutter of the vertically adjacent sub-compartment are aligned with respect to one another.

5. Stocker compartment according to any one of the preceding claims, wherein at least one of the plurality of shutters (128a to 128e) is secured in its respective positions defining closed and open states of the sub-compartments with which they are associated by means of a magnetic securing mechanism (410,420,430).

6. Stocker compartment according to any one of the preceding claims, wherein a guide rail mechanism (180) for guiding the shutters (128a to 128e) between their positions defining opening and closed states of respective sub-compartments with which they are associated is provided.

7. Stocker compartment according to claim 5 or 6, wherein the magnetic securing mechanism (410,420,430) and/or the guide rail-mechanism (180) is provided in a shielded environment (181) separated from each of the plurality of sub-compartments (120a to 120e).

8. Stocker compartment according to claim 7, wherein the shielded environment (181) for the guide rail mechanism is provided with an exhaust mechanism (190) for extracting particles generated during operation of the guide rail mechanism (180) from the shielded environment (181).

9. Stocker comprising at least one stocker compartment (110) according to any one of the preceding claims and a robot mechanism (130) configured and adapted to move each one of the plurality of shutters (128a to 128e) to provide an open or closed state of a sub-compartment (120a to 120e), with which a shutter moved by the robot mechanism (130) is associated.

10. Stocker according to claim 9, wherein the robot mechanism is further configured and adapted to handle EUV pod components, especially EIPs.
